# FASCICULE DE BREVET EUROPEEN

(11) **EP 0 619 637 B1**
(45) Date de publication et mention de la délivrance du brevet: **12.11.1997**
(21) Numéro de dépôt: 94410025.4
(22) Date de dépôt: 06.04.1994
(51) Int. Cl.: H02H 7/06, H02H 9/04, H01L 27/08

(54) **Protection d'un alternateur triphasé automobile**
Schutz eines Kraftfahrzeugdrehstromgenerators
Protection of an automobile three-phase alternator

(30) Priorité: 09.04.1993 FR 9304548
(43) Date de publication de la demande: 12.10.1994
(73) Titulaire: SGS-THOMSON MICROELECTRONICS S.A., 94250 Gentilly (FR)
(72) Inventeur: Pezzani, Robert, F-37210 Vouvray (FR); Berthiot, Denis, F-37000 Tours (FR)
(74) Mandataire: de Beaumont, Michel

(56) Documents cités:
- US-A- 3 488 560

## Description

La présente invention concerne les alternateurs triphasés et plus particulièrement les alternateurs triphasés utilisés pour la charge de la batterie d'un véhicule automobile.

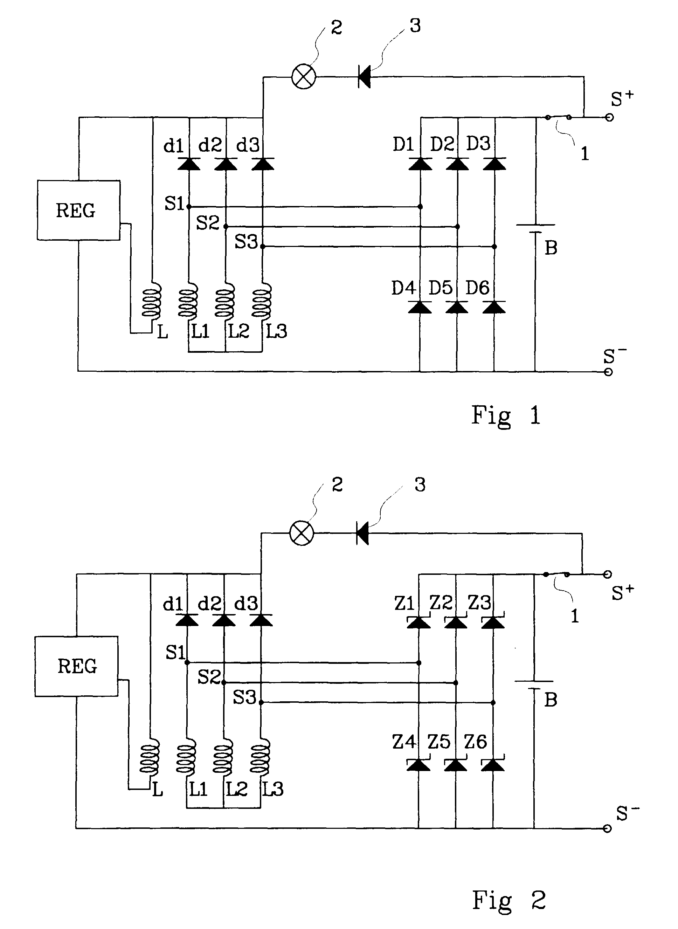

La figure 1 représente de façon très simplifiée le schéma d'ensemble d'un alternateur triphasé de charge d'une batterie automobile. L'alternateur comprend trois enroulements induits L1, L2, L3 interconnectés par l'une de leurs bornes et une bobine inductrice L. Le courant dans la bobine inductrice L est fixé par un régulateur (REG) qui tient compte d'une façon non représentée du courant dans la charge. Les bornes de sortie S1, S2, S3 de l'alternateur sont reliées par des diodes d1, d2, d3 à une première entrée du régulateur pour assurer son alimentation et par un pont redresseur aux bornes S⁺ et S⁻ qui sont les bornes positive et négative de la batterie B du véhicule automobile et qui sont reliées à divers circuits d'utilisation (réseau de bord). Le redresseur comprend des diodes D1, D2 et D3 reliées par leurs anodes aux sorties respectives S1, S2, S3 de l'alternateur et par leurs cathodes communes à la borne S⁺ (par l'intermédiaire d'un interrupteur 1 fermé par la clef de contact), et des diodes D4, D5, D6 reliées par leurs cathodes aux sorties respectives S1, S2, S3 et par leurs anodes communes à la borne S⁻.

Un voyant de charge 2 est connecté par l'intermédiaire d'une diode d'isolement 3 entre la borne S⁺ et l'alimentation positive du régulateur. Ce voyant s'allume quand la tension aux bornes du régulateur devient inférieure à la tension de batterie : en cas de défaut ou quand le contact est mis et que le moteur ne tourne pas.

Le régulateur fonctionne pour moduler la puissance fournie par l'alternateur en fonction de la puissance demandée. Toutefois, si la puissance demandée aux bornes S⁺, S⁻ chute brutalement, par exemple par suite d'un défaut de contact des cosses de batterie ou d'une extinction des phares, l'action du régulateur n'est pas immédiate et, pendant une durée qui est par exemple de l'ordre de quelques centaines de millisecondes, la tension aux bornes S1, S2, S3 et donc aux bornes S⁺ et S⁻ croît brutalement. En effet la puissance fournie par l'alternateur n'a pas varié alors que le courant a chuté brutalement. Ce phénomène de rupture de charge et de montée de tension est couramment désigné dans la technique par le terme anglo-saxon "LOAD DUMP". Dans le cas d'équipements automobiles traditionnels, ce phénomène est peu gênant. Toutefois, à l'heure actuelle, la puissance électrique disponible dans une automobile croît et on tend à incorporer un nombre de plus en plus important de composants électroniques actifs, réalisés sous forme de circuits intégrés, dans les équipements automobiles. Ces circuits intégrés sont très sensibles aux phénomènes de surtension et la surtension temporaire liée au LOAD DUMP, qui peut atteindre une centaine de volts, est susceptible d'entraîner une destruction des composants électroniques de bord ainsi également que du régulateur lui-même.

Diverses solutions ont été proposées dans l'art antérieur pour résoudre ce problème.

Une première solution connue est illustrée en figure 2. Elle consiste à remplacer chacune des diodes D1 à D6 par une diode à avalanche Z1 à Z6 dont la tension de claquage est supérieure à la tension maximale aux bornes de la batterie B. Par mesure de sécurité, on est amené à choisir ce seuil de claquage nettement supérieur à la tension de batterie. Ainsi, pour une batterie de 12 volts, on est communément amené à choisir des seuils de claquage de l'ordre de 30 volts. Une surtension sur l'une des bornes S1, S2, S3 sera donc écrêtée par l'une des diodes.

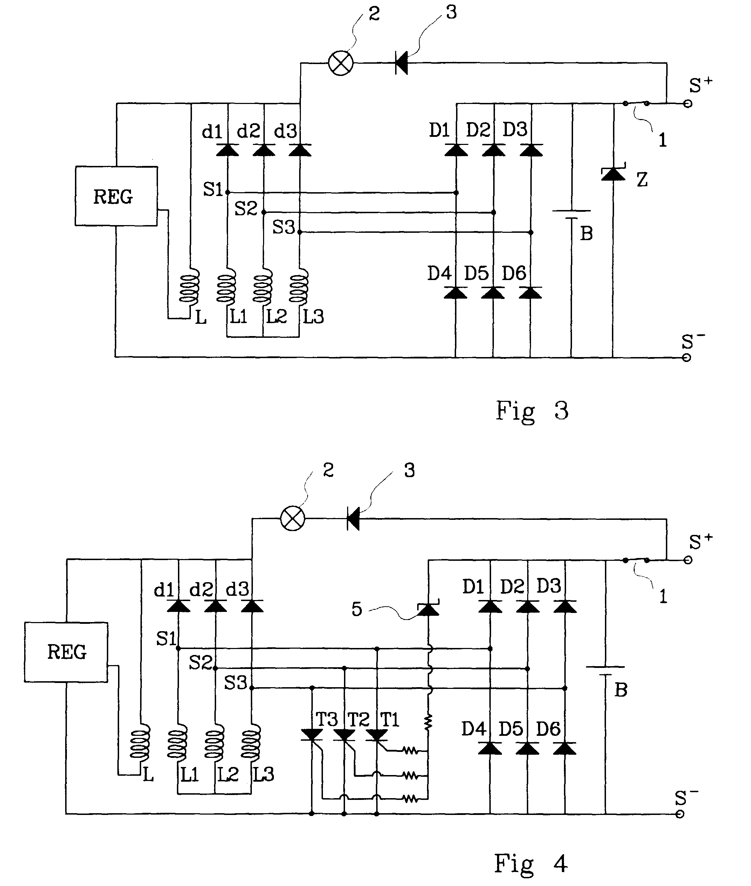

Une deuxième solution classique est illustrée en figure 3. Elle consiste à placer une diode à avalanche Z en parallèle sur la batterie B. A nouveau, cette diode à avalanche devra avoir une tension de seuil d'écrêtage de l'ordre de 30 V.

Ces deux solutions qui utilisent des diodes écrêteuses présentent un inconvénient fondamental de dissipation lié au fait que l'énergie pendant la phase de LOAD DUMP est relativement élevée, et correspond sensiblement au niveau d'énergie de la charge qui a été brutalement interrompue. Elle peut être de l'ordre de la centaine de joules. Et cette énergie sera dissipée dans les diodes d'écrêtage où passera un courant important. Ceci oblige à utiliser des diodes de grande dimension et/ou à utiliser plusieurs diodes en parallèle et à associer à ces diodes des radiateurs de dissipation de puissance. Ainsi, ces solutions nécessitent l'emploi de composants de grande surface associé à des boîtiers nécessitant un montage mécanique spécifique.

Une troisième solution est décrite dans le brevet américain 3 488 560 dont la figure 2 est sensiblement reproduite dans la figure 4 ci-jointe avec des modifications destinées à rendre cette figure homogène dans sa présentation avec les figures 1 à 3. Dans cette troisième solution, le circuit de protection contre le LOAD DUMP est constitué de trois thyristors T1, T2, T3 connectés entre chacune des sorties S1, S2, S3 de l'alternateur et la borne S⁻. Les gâchettes de ces thyristors sont reliées par l'intermédiaire de résistances à l'anode d'une diode à avalanche 5 dont la cathode est reliée à la borne S⁺.

En cas de LOAD DUMP, la tension entre les bornes S⁺ et S⁻ croît rapidement. Cette augmentation de tension provoque la mise en avalanche de la diode 5 et donc le passage de courant dans les gâchettes des thyristors T1, T2 et T3. Le thyristor dont l'anode est connectée à la borne la plus positive parmi les bornes S1, S2 et S3 à l'instant considéré entre en conduction et la surtension est renvoyée dans les autres enroulements par au moins une des diodes D4, D5 et D6. Ensuite, la conduction du thyristor cesse quand son anode n'est plus connectée à un potentiel positif et le dispositif de protection se bloque si la surcharge a cessé. Sinon, un autre des thyristors T1, T2, T3 (celui qui est connecté à la borne S1, S2, S3 la plus positive) prend le relais du précédent.

Un avantage de cette troisième solution est que l'on utilise des thyristors qui, quand ils sont conducteurs, présentent une très faible chute de tension à leurs bornes, dissipent peu d'énergie et peuvent donc être des composants de petites dimensions qu'il n'est pas nécessaire de monter sur des radiateurs.

Toutefois, cette troisième solution présente deux inconvénients principaux.

Le premier inconvénient est qu'elle est complexe et nécessite l'utilisation et la connexion de plusieurs composants individuels, à savoir au moins un premier composant intégrant les trois thyristors et un deuxième composant correspondant à la diode 5, et éventuellement des composants supplémentaires pour les résistances.

Le deuxième inconvénient est qu'elle ne protège pas le régulateur contre des surtensions du réseau ou que, si elle le fait, cela perturbe le fonctionnement du circuit. En effet, indépendamment des problèmes de LOAD DUMP, un réseau de bord automobile est susceptible de générer par lui-même de nombreuses perturbations résultant par exemple de l'allumage à travers une bobine et les bougies ou de variations de charge. Ces phénomènes génèrent des impulsions de faible durée (quelques microsecondes) mais qui peuvent atteindre jusqu'à 300 volts. Ces parasites d'énergie plus faible demeurent toutefois suffisamment énergétiques pour nuire à des composants du réseau de bord et sont susceptibles d'être transmis au régulateur par la diode 3 et le voyant 2 et de nuire aux circuits électroniques de ce régulateur. Or, ces surtensions ne sont pas écrêtées par le montage de la figure 4 où les diodes D1, D2, D3 bloquent ces surtensions et les empêchent d'être éliminées par les thyristors T1, T2, T3. Ces surtensions ne peuvent pas non plus être éliminées par la diode 5 et le trajet gâchette-cathode des thyristors T1, T2, T3 étant donné la présence de fortes résistances en série.

Ainsi, un objet de la présente invention est de réaliser un circuit de protection à la fois contre le LOAD DUMP et contre les surcharges en provenance du réseau de bord qui :
- présente une faible dissipation pendant les périodes de protection, et
- soit réalisable sous forme d'un composant monolithique.

Un autre objet de la présente invention est de prévoir un composant unique de protection d'alternateur automobile à la fois contre le LOAD DUMP et contre des surcharges en provenance du réseau de bord.

Pour atteindre ces objets, la présente invention prévoit un composant de protection d'un alternateur triphasé associé à un pont redresseur, comprenant trois diodes de Shockley et une diode à avalanche. Trois électrodes de première polarité des diodes de Shockley sont interconnectées avec l'électrode de polarité opposée de la diode à avalanche à une borne commune reliée à la borne de sortie de première polarité du redresseur. Chacune des deuxièmes électrodes des diodes de Shockley est connectée à chacune des sorties de l'alternateur et la deuxième borne de la diode à avalanche est reliée à la deuxième borne de sortie du pont.

Selon un mode de réalisation de la présente invention, la première borne de la diode à avalanche est reliée à la borne commune par l'intermédiaire d'une diode fonctionnant en direct quand la diode à avalanche est en avalanche.

Selon un mode de réalisation de la présente invention, le composant de protection est formé dans un substrat constitué d'une couche d'un premier type de conductivité revêtue d'une couche du deuxième type de conductivité, et comprend quatre caissons du premier type de conductivité formés dans la couche du deuxième type de conductivité ; des régions du deuxième type de conductivité formées dans trois des caissons ; des métallisations de face avant recouvrant les surfaces apparentes des quatre caissons ; et une métallisation de face arrière recouvrant la couche du premier type de conductivité ; d'où il résulte que la métallisation de face arrière correspond à la borne commune et les métallisations de face avant aux autres électrodes des diodes de Shockley et de la diode à avalanche, respectivement.

Selon un mode de réalisation de la présente invention, les quatre caissons sont de même niveau de dopage.

Selon un mode de réalisation de la présente invention, les régions du deuxième type de conductivité sont munies de trous de court-circuit.

Selon un mode de réalisation de la présente invention, le caisson correspondant à la diode à avalanche est de plus petite dimension que les autres caissons.

Ces objets, caractéristiques et avantages ainsi que d'autres de la présente invention seront exposés en détail dans la description suivante de modes de réalisation particuliers faite en relation avec les figures jointes parmi lesquelles :
les figures 1 à 4, décrites précédemment, illustrent des circuits d'alternateurs automobiles classiques ;
la figure 5 représente un mode de réalisation d'un circuit de protection selon la présente invention ;
la figure 6 représente une vue en coupe schématique d'un composant de protection selon la présente invention ; et
la figure 7 représente une vue de dessus d'un composant de protection selon la présente invention.

La présente invention se base sur une analyse des circuits existants de protection d'un alternateur de charge de batterie et sur une modification et une recombinaison de ces circuits pour atteindre les objets susmentionnés.

Plus particulièrement, la présente invention vise à prévoir comme circuit principal de protection contre le LOAD DUMP des éléments de protection ayant comme des thyristors une caractéristique de retournement, c'est-à-dire que ces composants une fois qu'ils sont mis en conduction présentent une très faible chute de tension à leurs bornes. Néanmoins, comme les thyristors selon l'art antérieur impliquaient la réalisation d'un circuit relativement complexe, la présente invention prévoit de remplacer ces thyristors par des diodes de Shockley ou thyristors sans gâchette qui sont des composants à quatre couches semiconductrices de types de conductivité alternés.

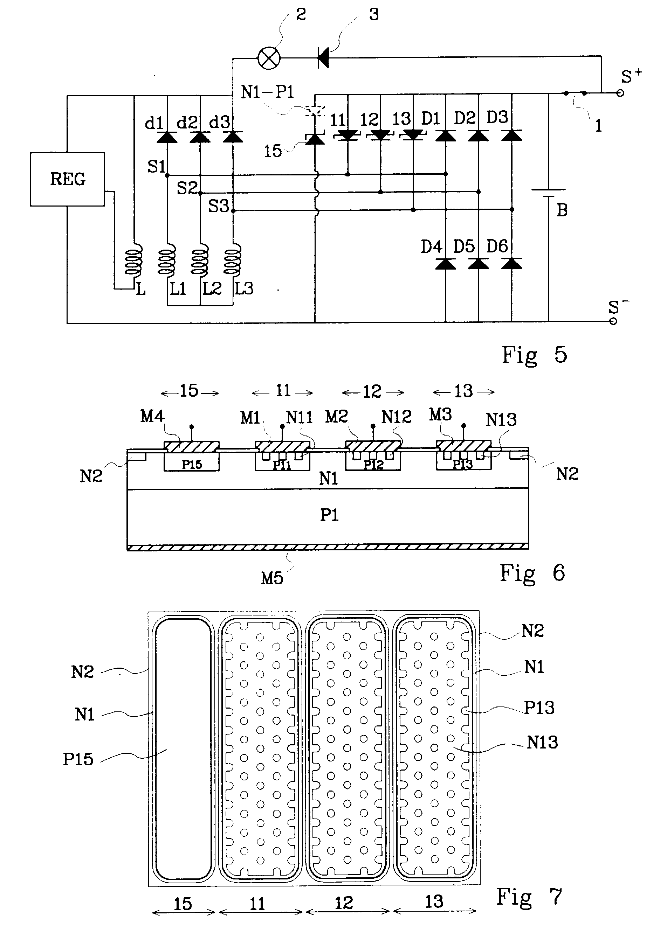

Dans le mode de réalisation de la figure 5, ces diodes de Shockley 11, 12 et 13 sont disposées entre la borne S⁺ et respectivement chacune des bornes S1, S2, S3 de l'alternateur, les anodes de ces diodes étant donc communes et reliées à la borne S⁺.

De façon connue, quand une tension s'élève positivement entre l'anode et la cathode d'un composant du type diode de Shockley, le courant dans le composant est pratiquement nul jusqu'à ce que l'on atteigne une tension dite tension d'avalanche VBR. Ensuite, le courant augmente relativement rapidement avec la tension jusqu'à une valeur de retournement VB0, après quoi la tension chute rapidement tandis que le courant est susceptible d'augmenter. Le composant se rebloque quand le courant qui le traverse devient inférieur à un courant de maintien IH.

Les composants 11, 12, 13 sont choisis pour que leur tension VBR soit supérieure à la tension maximale de batterie, et que VB0 soit inférieure à la tension maximale supportable par les circuits de bord à protéger. Dans le cas d'une batterie de 12 volts, on choisira VBR supérieure à 16 V (par exemple 20 V) et VB0 inférieure à 40 V (par exemple 28 V). La taille de ces composants doit être suffisante pour écouler le courant direct défini par l'énergie de Load Dump qui peut atteindre une centaine d'ampères. En pratique, la taille de chaque composant sera bien inférieure à celle d'une diode d'écrêtage soumise à la même surcharge.

Le fonctionnement du dispositif de protection selon l'invention sera exposé en tenant compte du fait que l'on a aux bornes de chacun des enroulements S1, S2 et S3 des tensions alternatives sinusoïdales déphasées de 120°. Ainsi, chacune des diodes D1, D2, D3 conduit quand la tension à la borne correspondante est maximale.

Si le phénomène de LOAD DUMP survient tandis que la diode D1 est conductrice, alors, la diode de Shockley aux bornes de laquelle la différence de potentiel est la plus élevée parmi les diodes 12 et 13, passe en conduction et le circuit se referme sur l'enroulement L2 et/ou L3. Ce phénomène se répète avec une mise en conduction successive des diodes de Shockley 11, 12 et 13 jusqu'à ce que l'excursion de tension fournie par l'alternateur devienne inférieure à la tension de retournement de ces diodes.

On élimine donc selon l'invention l'effet du LOAD DUMP sur les bornes S⁺ et S⁻ et les circuits auxquels elles sont connectées en renvoyant les surtensions produites par un enroulement de l'alternateur vers un autre enroulement de cet alternateur. On notera que le désamorçage de la diode de Shockley mise en conduction par suite d'un LOAD DUMP est automatiquement obtenu en raison des alternances de polarité des enroulements de l'alternateur triphasé.

En outre, comme cela est représenté en figure 5, la présente invention prévoit de disposer une diode à avalanche 15 en parallèle entre les bornes S⁺ et S⁻ pour éliminer les surtensions brèves susceptibles d'être générées par certains des organes du réseau de bord. En effet, les diodes D1 à D6 sont polarisées de telle sorte qu'une surtension positive sur la borne S⁺ ne peut être éliminée par les diodes de Shockley 11, 12 et 13. Par contre, une telle surtension mettra en conduction la diode à avalanche 15 qui assurera la protection par écrêtage des autres éléments du réseau de bord et du régulateur. Comme ces surtensions en provenance du réseau de bord ont éventuellement une forte tension mais une faible énergie, il suffira d'utiliser une diode 15 de petite dimension.

La diode 15 n'est pas active en cas de LOAD DUMP à condition d'avoir une tension d'avalanche supérieure ou égale à la tension de retournement des diodes de Shockley 11 à 13. En effet, si cette tension d'avalanche est égale à la tension de retournement, étant donné qu'une diode à avalanche présente une résistance dynamique élevée, sa mise en conduction sera immédiatement relayée par la mise en conduction de l'une ou l'autre des diodes de Shockley 11 à 13. La tension aux bornes de la diode 15 deviendra alors immédiatement inférieure à la tension d'avalanche et la diode 15 se rebloquera.

Ainsi, le circuit selon la présente invention présente comme le circuit de l'art antérieur illustré en relation avec la figure 4 l'avantage d'utiliser seulement des composants de petite dimension mais il présente en plus l'avantage d'assurer une protection contre des surtensions apparaissant sur le réseau de bord. Et il présente aussi, comme cela sera exposé ci-après, l'avantage de pouvoir être réalisé sous forme d'un composant unique.

La figure 6 représente une vue en coupe d'un composant monolithique selon la présente invention intégrant trois diodes de Shockley à anode commune et une diode à avalanche dont la cathode est reliée aux anodes communes des diodes de Shockley. Ce composant est construit à partir d'un substrat comprenant une couche inférieure de type P, P1, et une couche supérieure de type N, N1. La couche N1 peut être formée par épitaxie sur un substrat P, ou bien on peut partir d'un substrat de type N et y former la région P1 par diffusion. La concentration en dopants dans la région P1 est de l'ordre de 10¹⁹ atomes/cm³ et la concentration dans la région N1 de l'ordre de 10¹⁵ atomes/cm³.

Dans la région N1 sont formés par diffusion des caissons de type P, respectivement P11, P12, P13 et P15. Dans les caissons P11, P12, P13 sont respectivement formées des régions de type N, N11, N12 et N13. Des métallisations M1, M2 et M3, qui revêtent la face supérieure des caissons P11, P12 et P13, sont en contact avec les régions N11, N12 et N13 et des portions apparentes des caissons P11, P12 et P13. Une métallisation M4 revêt le caisson P15. Une métallisation M5 recouvre la face arrière de la couche P1.

Les métallisations M1, M2 et M3 correspondent respectivement aux cathodes de diodes de Shockley 11, 12 et 13 dont la métallisation M5 constitue l'anode commune. La métallisation M4 correspond à l'anode d'une diode à avalanche 15 dont la cathode est constituée par la couche N1 qui est liée à la métallisation M5 par l'intermédiaire de la couche P1. Ainsi, en fait, il existe une jonction N1-P1 formant diode entre la cathode de la diode à avalanche 15 et la métallisation commune M5. Cette diode N1-P1, qui a été représentée en pointillés en figure 5, a sa cathode reliée à la cathode de la diode 15 et ne présente aucun inconvénient pour l'application envisagée puisque la diode 15 est uniquement destinée à fonctionner en avalanche en tant que composant de protection, et jamais en direct.

Les caissons P11, P12, P13 et P15 peuvent être réalisés lors de la même opération et présenteront alors des caractéristiques de claquage identiques. Le choix du dopage de ces caissons en relation avec celui de la couche N1 permet entre autres l'ajustement de la tension VB0 des diodes de Shockley et de la tension d'avalanche de la diode 15. Le caisson P15 aura de préférence une plus petite surface que les caissons P11 à P13 pour augmenter la résistance dynamique de la diode à avalanche et favoriser le déclenchement initial des diodes de Shockley en cas de LOAD DUMP. Classiquement, pour atteindre des tensions de claquage comprises entre 10 et 30 volts, les caissons P auront des profondeurs de diffusion de 5 à 15 micromètres pour une concentration de surface de l'ordre de 10¹⁸ atomes/cm³. La couche N1 aura classiquement une épaisseur de l'ordre de 20 à 80 micromètres et les régions N11, N12 et N13 des concentrations de surface de l'ordre de 10²⁰ atomes/cm³ pour une profondeur de 1 à 5 micromètres.

On a également représenté en figure 6 un anneau de garde N2, surdopé de type N, à la périphérie du composant et une couche mince d'oxyde (non reférencée) à la surface supérieure du composant en dehors des zones de contact des métallisations M1 à M4.

Le composant de la figure 6 pourra ensuite être mis classiquement dans un boîtier à cinq connexions correspondant respectivement aux métallisations M1 à M5 et ce boîtier sera connecté de la façon illustrée en figure 5 à un ensemble alternateur triphasé/redresseur.

La présente invention est susceptible de nombreuses variantes qui apparaîtront à l'homme de l'art notamment en ce qui concerne la réalisation du composant de la figure 6. En outre, on notera que tous les types de conductivité du composant illustré en figure 6 pourront être inversés pour fournir un composant de protection comprenant trois diodes de Shockley à cathode commune et une diode à avalanche dont l'anode est reliée à ces cathodes communes. En ce cas, les diodes de Shockley seront connectées entre chacune des sorties S1, S2, S3 de l'alternateur et la borne de sortie S⁻ de la figure 5, et la métallisation commune du boîtier pourra être reliée à la masse du véhicule.

La figure 7 représente à titre d'exemple une vue de dessus d'un composant selon l'invention. Cette vue ne correspond pas exactement à la vue en coupe de la figure 6. En particulier, la région N2 s'étend entre chacun des éléments du composant. A titre d'exemple, pour une application automobile, la surface de chacune des diodes de Shockley 11, 12, 13 sera de l'ordre de 6 mm² et la surface de la diode à avalanche 15 sera de l'ordre de 3 à 4 mm², ce qui donne une surface totale du composant de l'ordre de 25 mm². On notera que, pour une même application, la diode Z de la figure 3 devrait avoir une surface deux à trois fois plus importante.

## Revendications

1. Composant de protection d'un alternateur triphasé associé à un pont redresseur, caractérisé en ce qu'il comprend trois diodes de Shockley (11, 12, 13) et une diode à avalanche (15), trois électrodes de première polarité des diodes de Shockley étant interconnectées avec l'électrode de polarité opposée de la diode à avalanche à une borne commune reliée à la borne de sortie (S⁺) de première polarité du redresseur, chacune des deuxièmes électrodes des diodes de Shockley étant connectée à chacune des sorties (S1, S2, S3) de l'alternateur, et la deuxième borne de la diode à avalanche étant reliée à la deuxième borne de sortie (S⁻) du redresseur.

2. Composant de protection selon la revendication 1, caractérisé en ce que la première borne de la diode à avalanche est reliée à la borne commune par l'intermédiaire d'une diode (P1-N1) fonctionnant en direct quand la diode à avalanche est en avalanche.

3. Composant de protection selon la revendication 2, formé dans un substrat constitué d'une couche d'un premier type de conductivité (P1) revêtue d'une couche du deuxième type de conductivité (N1), caractérisé en ce qu'il comprend :
quatre caissons du premier type de conductivité (P11, P12, P13, P15) formés dans ladite couche du deuxième type de conductivité (N1),
des régions du deuxième type de conductivité (N11, N12, N13) formées dans trois des caissons,
des métallisations de face avant (M1 à M4) recouvrant les surfaces apparentes des quatre caissons, et
une métallisation de face arrière (M5) recouvrant ladite couche du premier type de conductivité (P1),
d'où il résulte que la métallisation de face arrière correspond à ladite borne commune et les métallisations de face avant aux autres électrodes des diodes de Shockley et de la diode à avalanche, respectivement.

4. Composant de protection selon la revendication 3, caractérisé en ce que les régions du deuxième type de conductivité (N11, N12, N13) sont munies de trous de court-circuit.

5. Composant de protection selon la revendication 3, caractérisé en ce que les quatre caissons sont de même niveau de dopage.

6. Composant de protection selon la revendication 5, caractérisé en ce que le caisson correspondant à la diode à avalanche est de plus petite dimension que les autres caissons.

## Patentansprüche

1. Vorrichtung bzw. Bauteil zum Schutz eines mit einer Gleichrichtbrücke verbundenen Dreiphasen-Wechselstromgenerators (Drehstromgenerators),
dadurch gekennzeichnet, daß die Vorrichtung bzw. das Bauteil drei Shockley-Dioden (11, 12, 13) und eine Lawinendiode (Zener-Diode) (15) aufweist, wobei drei Elektroden einer ersten Polarität der Shockley-Dioden zusammen mit einer Elektrode der Lawinendiode von der entgegengesetzten Polarität mit einem gemeinsamen Anschluß verbunden sind, der mit dem Ausgangsanschluß (S⁺) einer ersten Polarität des Gleichrichters verbunden ist, wobei jeweils die zweite Elektrode jeder der Shockley-Dioden mit jeweils einem Ausgang (S1, S2, S3) des Generators verbunden ist, und wobei der zweite Anschluß der Lawinendiode mit dem zweiten Ausgangsanschluß (S⁻) des Gleichrichters verbunden ist.

2. Schutzvorrichtung bzw. -bauteil nach Anspruch 1, dadurch gekennzeichnet, daß der erste Anschluß der Lawinendiode mit dem gemeinsamen Anschluß über eine Diode (P1-N1) verbunden ist, die sich im Leitungszustand befindet, wenn die Lawinendiode sich im Lawinen-Durchbruchzustand befindet.

3. Schutzvorrichtung bzw. -bauteil nach Anspruch 2, in Ausbildung in einem Substrat, welches aus einer Schicht eines ersten Leitfähigkeitstyps (P1), die mit einer Schicht vom zweiten Leitfähigkeitstyp (N1) überzogen ist, besteht, dadurch gekennzeichnet, daß die Vorrichtung bzw. das Bauteil aufweist:
- vier Gräben vom ersten Leitfähigkeitstyp (P11, P12, P13, P15), die in der genannten Schicht vom zweiten Leitfähigkeitstyp (N1) erzeugt sind,
- in drei der Gräben gebildete Bereiche vom zweiten Leitfähigkeitstyp (N11, N12, N13),
- Stirnflächen-Metallisierungen (M1 bis M4), welche die freiliegenden Oberflächen der vier Gräben bedecken, sowie
- eine Rückseiten-Metallisierung (M5), welche die genannte Schicht vom ersten Leitfähigkeitstyp (P1) bedeckt,
derart, daß die Metallisierung auf der Rückseite dem genannten gemeinsamen Anschluß entspricht und die Vorderseiten-Metallisierungen den anderen Elektroden der Shockley-Dioden bzw. der Lawinendiode entsprechen.

4. Schutzvorrichtung bzw. -bauteil nach Anspruch 3, dadurch gekennzeichnet, daß die Bereiche vom zweiten Leitfähigkeitstyp (N11, N12, N13) mit Kurzschluß-Öffnungen versehen sind.

5. Schutzvorrichtung bzw. -bauteil nach Anspruch 3, dadurch gekennzeichnet, daß die vier Gräben den gleichen Dotierungspegel aufweisen.

6. Schutzvorrichtung bzw. -bauteil nach Anspruch 5, dadurch gekennzeichnet, daß der der Lawinendiode entsprechende Graben von kleinerer Abmessung als die anderen Gräben ist.

## Claims

1. A protection component for a three-phase alternator associated with a rectifying bridge, characterized in that it includes three Shockley diodes (11, 12, 13) and an avalanche diode (15), three electrodes, of a first polarity, of the Shockley diodes being interconnected with an electrode, of the opposite polarity, of the avalanche diode to a common terminal that is connected to the output terminal (S⁺), having a first polarity, of the rectifier, each second electrode of the Shockley diodes being connected to each output (S1, S2, S3) of the alternator, and the second terminal of the avalanche diode being connected to the second output terminal (S⁻) of the rectifier.

2. The protection component of claim 1, characterized in that the first terminal of the avalanche diode is connected to the common terminal through a diode (P1-N1), forward-conducting when the avalanche diode is in avalanche mode.

3. The protection component of claim 2, formed in a substrate constituted by a layer (P1) of a first conductivity type coated with a layer (N1) of the second conductivity type, characterized in that it comprises:
four wells (P11, P12, P13, P15) of the first conductivity type formed in said layer (N1) of the second conductivity type,
regions (N11, N12, N13) of the second conductivity type formed in three of said wells,
front surface metallizations (M1-M4) coating the apparent surfaces of the four wells, and
a rear surface metallization (M5) coating said layer (P1) of the first conductivity type,
whereby the rear surface metallization corresponds to said common terminal and the front surface metallizations correspond to the other electrodes of the Shockley diodes and of the avalanche diode, respectively.

4. The protection component of claim 3, characterized in that said regions (N11, N12, N13) of the second conductivity type are provided with shorting holes.

5. The protection component of claim 3, characterized in that the four wells have the same doping level.

6. The protection component of claim 5, characterized in that the well corresponding to the avalanche diode is smaller than the other wells.
